# DEMANDE DE BREVET EUROPEEN

(11) **EP 3 664 164 A1**
(43) Date de publication de la demande: **10.06.2020**
(21) Numéro de dépôt: 19213027.6
(22) Date de dépôt: 02.12.2019
(51) Int. Cl.: H01L 31/107, H01L 31/0352

(54) **PHOTODIODE DE TYPE SPAD**

(30) Priorité: 07.12.2018 FR 1872508
(71) Demandeur: Commissariat à l'Energie Atomique et aux Energies Alternatives, 75015 Paris (FR)
(72) Inventeur: GIROUD-GARAMPON, Cédric, 38054 Grenoble Cedex 9 (FR); MOUSSY, Norbert, 38054 Grenoble Cedex 9 (FR); SAXOD, Olivier, 38054 Grenoble Cedex 9 (FR)
(74) Mandataire: Cabinet Beaumont

(57) **Abrégé**

La présente description concerne une photodiode de type SPAD (100) comportant, dans une partie supérieure d'un substrat semiconducteur (101) d'un premier type de conductivité, une alternance de régions (107_j) du premier type de conductivité et de régions (105_i) d'un second type de conductivité empilées verticalement, les régions (107_j) du premier type de conductivité étant en contact avec un même premier via semiconducteur (117) du premier type de conductivité et les régions (105_i) du second type de conductivité étant en contact avec un même second via semiconducteur (115) du second type de conductivité.

## Description

### Domaine technique

La présente demande concerne le domaine des photodiodes à avalanche pour la détection de photons uniques, aussi appelées photodiodes SPAD (de l'anglais "Single Photon Avalanche Diode").

### Technique antérieure

Une photodiode SPAD est essentiellement constituée par une jonction PN polarisée en inverse à une tension supérieure à son seuil d'avalanche. Lorsqu'aucune charge électrique n'est présente dans la zone de déplétion ou zone de charge d'espace de la jonction PN, la photodiode est dans un état pseudo-stable, non conducteur. Lorsqu'une charge électrique photogénérée est injectée dans la zone de déplétion, si la vitesse de déplacement de cette charge dans la zone de déplétion est suffisamment élevée, c'est-à-dire si le champ électrique dans la zone de déplétion est suffisamment intense, la photodiode est susceptible d'entrer en avalanche. Un seul photon est ainsi capable de générer un signal électrique mesurable, et ce avec un temps de réponse très court. Les photodiodes SPAD permettent de détecter des rayonnements de très faible intensité lumineuse, et sont notamment utilisées pour la détection de photons uniques et le comptage de photons.

Il serait souhaitable de pouvoir améliorer au moins en partie certains aspects des photodiodes SPAD connues.

### Résumé de l'invention

Ainsi, un mode de réalisation prévoit une photodiode de type SPAD comportant, dans une partie supérieure d'un substrat semiconducteur d'un premier type de conductivité, une alternance de régions du premier type de conductivité et de régions d'un second type de conductivité empilées verticalement, les régions du premier type de conductivité étant en contact avec un même premier via semiconducteur du premier type de conductivité et les régions du second type de conductivité étant en contact avec un même second via semiconducteur du second type de conductivité.

Selon un mode de réalisation, l'alternance de régions du premier type de conductivité et de régions du second type de conductivité forme un empilement vertical d'une pluralité de jonctions PN définissant chacune une zone d'avalanche de la photodiode.

Selon un mode de réalisation, les jonctions PN ont toutes sensiblement la même tension d'avalanche.

Selon un mode de réalisation, les régions du premier type de conductivité ont un niveau de dopage supérieur à celui du substrat.

Selon un mode de réalisation, dans une première partie d'une région périphérique de la photodiode, les régions du premier type de conductivité se prolongent latéralement au-delà des régions du second type de conductivité, et, dans une deuxième partie de la région périphérique de la photodiode, les régions du second type de conductivité se prolongent latéralement au-delà des régions du premier type de conductivité, le premier via semiconducteur étant disposé dans la première partie de la région périphérique de la photodiode et le second via semiconducteur étant disposé dans la deuxième partie de la région périphérique de la photodiode.

Selon un mode de réalisation, à l'exception des régions extrêmes de ladite alternance, chaque région du premier type de conductivité est en contact, par sa face inférieure, avec l'une des régions du second type de conductivité, et, par sa face supérieure, avec une autre des régions du second type de conductivité, et chaque région du second type de conductivité est en contact, par sa face inférieure, avec l'une des régions du premier type de conductivité, et, par sa face supérieure, avec une autre des régions du premier type de conductivité.

Selon un mode de réalisation, les régions du premier type de conductivité et les régions du second type de conductivité ont sensiblement la même épaisseur.

Selon un mode de réalisation, les régions du premier type de conductivité ont une épaisseur supérieure à l'épaisseur des régions du second type de conductivité.

Selon un mode de réalisation, chaque région du premier type de conductivité est en contact avec une seule région du second type de conductivité.

Selon un mode de réalisation, chaque région du second type de conductivité est en contact, par sa face inférieure, avec l'une des régions du premier type de conductivité et, par sa face supérieure, avec une autre des régions du premier type de conductivité.

Selon un mode de réalisation :
- au moins l'une des régions du second type de conductivité est en contact, par sa face inférieure, avec l'une des régions du premier type de conductivité et, par sa face supérieure, avec une autre des régions du premier type de conductivité ; et
- au moins une autre des régions du second type de conductivité est en contact avec une seule des régions du premier type de conductivité.

Selon un mode de réalisation, les premier et second types de conductivité sont respectivement le type P et le type N.

Un autre mode de réalisation prévoit un procédé de fabrication d'une photodiode de type SPAD telle que définie ci-dessus, dans lequel le substrat est formé par une suite d'étapes successives d'épitaxie.

Selon un mode de réalisation, deux étapes successives quelconques de la suite d'étapes successives d'épitaxie sont séparées par au moins une étape d'implantation localisée d'éléments dopants en vue de la formation d'au moins une des régions du premier ou second type de conductivité.

Selon un mode de réalisation, le procédé ne comprend pas de recuit d'activation des éléments dopants entre deux étapes successives de la suite d'étapes d'épitaxie, le procédé comprenant un unique recuit d'activation des éléments dopants commun à toutes les régions des premier et second types de conductivité à l'issue de la suite d'étapes successives d'épitaxie.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe schématique et partielle d'un exemple d'une photodiode SPAD selon un mode de réalisation ;
la figure 2 est une vue de dessus schématique et partielle de la photodiode SPAD de la figure 1 ;
la figure 3 est une vue en coupe schématique et partielle illustrant une étape d'un exemple de procédé de fabrication de la photodiode SPAD de la figure 1 ;
la figure 4 est une vue en coupe schématique et partielle illustrant une autre étape d'un exemple de procédé de fabrication de la photodiode SPAD de la figure 1 ;
la figure 5 est une vue en coupe schématique et partielle illustrant une autre étape d'un exemple de procédé de fabrication de la photodiode SPAD de la figure 1 ;
la figure 6 est une vue en coupe schématique et partielle illustrant une autre étape d'un exemple de procédé de fabrication de la photodiode SPAD de la figure 1 ;
la figure 7 est une vue en coupe schématique et partielle illustrant une autre étape d'un exemple de procédé de fabrication de la photodiode SPAD de la figure 1 ;
la figure 8 est une vue en coupe schématique et partielle illustrant une autre étape d'un exemple de procédé de fabrication de la photodiode SPAD de la figure 1 ;
la figure 9 est une vue en coupe schématique et partielle d'un autre exemple d'une photodiode SPAD selon un mode de réalisation ;
la figure 10 est une vue en coupe schématique et partielle d'un autre exemple d'une photodiode SPAD selon un mode de réalisation ; et
la figure 11 est une vue en coupe schématique et partielle d'un autre exemple d'une photodiode SPAD selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, une photodiode SPAD comprend généralement des circuits annexes, notamment un circuit de polarisation de sa jonction PN à une tension supérieure à son seuil d'avalanche, un circuit de lecture adapté à détecter un déclenchement d'une avalanche de la photodiode, ainsi qu'un circuit d'extinction ("quenching circuit" en anglais) ayant pour fonction d'interrompre l'avalanche de la photodiode une fois celle-ci déclenchée. Ces circuits annexes n'ont pas été représentés sur les figures et ne seront pas détaillés, les modes de réalisation décrits étant compatibles avec les circuits annexes équipant les photodiodes SPAD connues.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", "latéral", etc., il est fait référence sauf précision contraire à l'orientation des figures, étant entendu que, en pratique, les dispositifs décrits peuvent être orientés différemment.

Sauf précision contraire, les expressions "environ", "approximativement", "sensiblement", et "de l'ordre de" signifient à 10 % près, de préférence à 5 % près.

Un problème qui se pose dans les photodiodes SPAD connues est celui de la collecte des charges photogénérées en profondeur dans le substrat, à une distance éloignée de la zone d'avalanche de la photodiode, c'est-à-dire la partie de la zone de déplétion de la photodiode dans laquelle le champ électrique est suffisamment intense pour que l'avalanche puisse être déclenchée par une charge unique. En effet, au-delà d'une certaine distance de la jonction PN, le champ électrique résultant de la polarisation en inverse de la jonction PN s'annule ou s'atténue fortement, et ne permet plus d'entrainer les charges photogénérées vers la zone d'avalanche. Seule la diffusion aléatoire dans le substrat est alors susceptible de conduire les charges photogénérées vers la zone d'avalanche, avec une probabilité non négligeable que les charges photogénérées n'atteignent jamais la zone d'avalanche ou l'atteignent avec un retard important. Ce problème se pose notamment lorsque l'on souhaite collecter des charges photogénérées sous l'effet d'un rayonnement lumineux de longueur d'onde élevée, par exemple un rayonnement de longueur d'onde comprise entre 750 et 1200 nm dans le silicium.

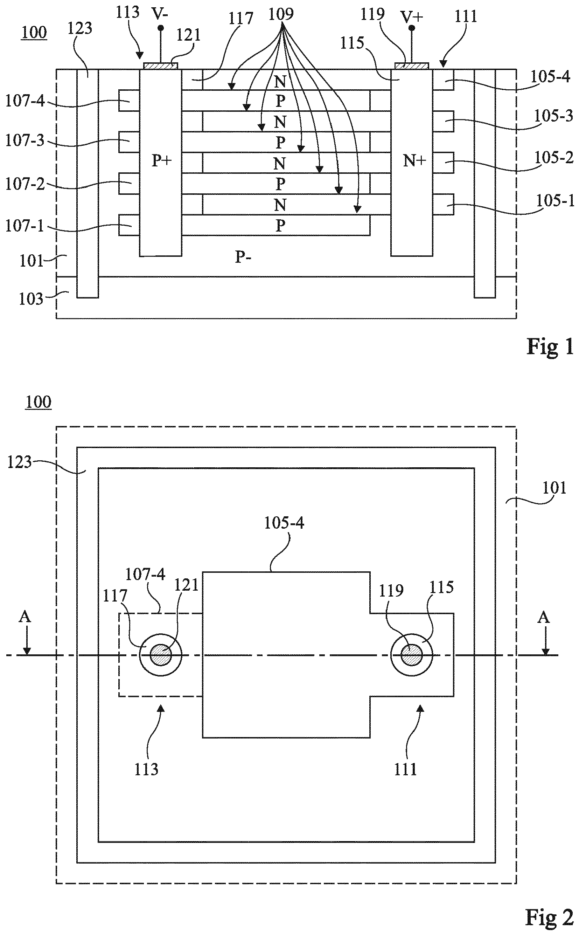

Les figures 1 et 2 sont respectivement une vue en coupe et une vue de dessus schématiques et partielles d'un exemple d'une photodiode SPAD 100 selon un mode de réalisation. La figure 1 est une vue en coupe selon le plan A-A de la figure 2.

La photodiode 100 comprend un substrat semiconducteur 101, par exemple en silicium. Dans l'exemple représenté, le substrat 101 est dopé de type P (P-). Dans cet exemple, la face inférieure du substrat 101 repose sur la face supérieure d'une couche support 103, par exemple une couche isolante, par exemple une couche d'oxyde de silicium. La couche 103 peut elle-même reposer sur un substrat de support non représenté, par exemple en silicium. A titre d'exemple, la couche 103 correspond à une couche d'oxyde enterrée d'une structure de type semiconducteur sur isolant (SOI). A titre de variante, la couche 103 est une couche semiconductrice, par exemple en le même matériau que le substrat 101, par exemple de type conductivité opposé à celui du substrat 101.

La photodiode 100 comprend en outre, dans une partie supérieure du substrat 101, une alternance de régions semiconductrices de types de conductivité opposés empilées verticalement, formant une pluralité de jonctions PN horizontales superposées, chaque jonction PN définissant une zone d'avalanche de la photodiode.

Plus particulièrement, dans l'exemple représenté, la photodiode 100 comprend, dans une partie supérieure du substrat 101, une alternance de régions 105_i dopées de type N (N) et de régions 107_j dopées de type P (P) empilées verticalement, avec i entier allant de 1 à m et m entier supérieur ou égal à 2 désignant le nombre de régions 105_i de type N de la photodiode, et avec j entier allant de 1 à n et n entier supérieur ou égal à 2 désignant le nombre de régions 107_j de type P de la photodiode. Dans l'exemple des figures 1 et 2, n=m, c'est-à-dire que la photodiode comprend autant de régions 105_i de type N que de régions 107_j de type P. Plus particulièrement, dans l'exemple représenté, m=n=4. Les régions 105_i et 107_j sont par exemple en le même matériau semiconducteur que le substrat 101, par exemple en silicium. Les régions 107_j ont un niveau de dopage de type P supérieur à celui du substrat 101. De préférence, les régions 105_i ont toutes sensiblement le même niveau de dopage de type N et les régions 107_j ont toutes sensiblement le même niveau de dopage de type P.

Dans l'exemple des figures 1 et 2, chaque région de type N 105_i, à l'exception de la région 105_m, est en contact, par sa face inférieure, avec la région de type P 107_j de rang j=i, et par sa face supérieure, avec la région de type P 107_j de rang j=i+1. Dans l'exemple représenté, la face inférieure de la région de type P 107_1 est en contact, sur sensiblement toute sa surface, avec le substrat 101. A titre de variante, la face inférieure de la région de type P 107_1 peut être en contact avec la couche 103. Dans l'exemple représenté, la face supérieure de la région 105_m affleure au niveau de la face supérieure du substrat 101. La face supérieure de la région 105_m est par exemple en contact avec une couche isolante de passivation (non représentée) de la face supérieure de la photodiode, par exemple en oxyde de silicium. A titre de variante, la face supérieure de la région de type N 105_m peut être située sous la surface supérieure du substrat 101, auquel cas la face supérieure de la région 105_m est en contact avec le substrat 101.

Ainsi, l'empilement vertical des régions 105_i et 107_j comprend (2^{∗}m)-1 jonctions PN 109 entre régions 105_i et 107_j voisines, soit 7 jonctions PN 109 dans l'exemple représenté. Les jonctions PN 109 sont sensiblement horizontales (i.e. parallèles aux faces principales du substrat 101) et alignées verticalement (i.e. en vis-à-vis ou à l'aplomb les unes des autres).

Dans l'exemple des figures 1 et 2, dans une partie 111 d'une région périphérique de la photodiode (du côté droit de la photodiode dans les vues des figures 1 et 2), les régions de type N 105_i se prolongent latéralement au-delà des régions de type P 107_j. De plus, dans autre partie 113 d'une région périphérique de la photodiode (du côté gauche de la photodiode dans la vue en coupe de la figure 1), les régions de type P 107_j se prolongent latéralement au-delà des régions de type N 105_i.

La photodiode 100 des figures 1 et 2 comprend en outre, dans la partie périphérique 111 de la photodiode, un via 115 rempli d'un matériau semiconducteur dopé de type N (N+) s'étendant verticalement depuis la face supérieure du substrat 101 jusqu'à la région semiconductrice de type N 105_1, à travers notamment les régions de type N 105_m à 105_2. Le via 115 est en contact avec chacune des régions semiconductrices de type N 105_i de la photodiode. Autrement dit, toutes les régions 105_i de la photodiode sont connectées les unes aux autres par l'intermédiaire du via 115. Le via 115 n'est en revanche pas en contact avec les régions semiconductrices de type P 107_j de la photodiode. Plus particulièrement, chaque région de type P 107_j de la photodiode est séparée du via 115 par une portion du substrat 101. Le via 115 est par exemple en silicium polycristallin dopé de type N, ou en silicium épitaxié dopé de type N. Le niveau de dopage du via 115 (N+) est de préférence supérieur à celui des régions 105_i.

La photodiode 100 des figures 1 et 2 comprend de plus, dans la partie périphérique 113 de la photodiode, un via 117 rempli d'un matériau semiconducteur dopé de type P (P+) s'étendant verticalement depuis la face supérieure du substrat 101 jusqu'à la région semiconductrice de type P 107_1, à travers notamment les régions de type P 107_n à 107_2. Le via 117 est en contact avec chacune des régions semiconductrices de type P 107_j de la photodiode. Autrement dit, toutes les régions 107_j de la photodiode sont connectées les unes aux autres par le via 117. Le via 117 n'est en revanche pas en contact avec les régions semiconductrices de type N 105_i de la photodiode. Plus particulièrement, chaque région de type N 105_i de la photodiode est séparée du via 117 par une portion du substrat 101. Le via 117 est par exemple en silicium polycristallin dopé de type P, ou en silicium épitaxié dopé de type P. Le niveau de dopage du via 117 (N+) est de préférence supérieur à celui des régions 107_j.

Dans l'exemple représenté, le via 115 est en contact, par sa face supérieure, avec une métallisation de contact de cathode 119 de la photodiode, et le via 117 est en contact, par sa face supérieure, avec une métallisation de contact d'anode 121 de la photodiode.

Dans l'exemple représenté, la photodiode 100 est entourée latéralement par un mur d'isolation périphérique 123 s'étendant verticalement depuis la face supérieure du substrat 101 jusqu'à la couche 103. Le mur d'isolation 123 est par exemple constitué d'une tranchée remplie d'un matériau isolant, par exemple de l'oxyde de silicium. A titre de variante, le mur 123 comprend une région centrale conductrice (par exemple en métal) ou semiconductrice (par exemple en silicium polycristallin dopé) isolée du substrat 101 par des parois latérales isolantes (non détaillées sur les figures 1 et 2). Cette variante permet par exemple de polariser électriquement la couche 103 depuis la face supérieure de la photodiode dans le cas où la couche 103 est en un matériau semiconducteur.

En fonctionnement, les régions 105_i, formant des régions de cathode de la photodiode, sont polarisées à un potentiel positif V+ par l'intermédiaire du via 115, et les régions 107_j, formant des régions d'anode de la photodiode, sont polarisées à un potentiel négatif V- par l'intermédiaire du via 117, de façon que la tension cathode-anode de la photodiode soit supérieure à sa tension d'avalanche.

Les niveaux de dopage des régions 105_i et 107_j et la tension de polarisation de la photodiode sont choisis de façon que le champ électrique dans la zone de charge d'espace de chaque jonction PN 109 soit suffisamment intense pour que l'avalanche puisse être déclenchée par une charge photogénérée unique, par exemple supérieur à 500 kV/cm.

De préférence, le niveau de dopage du substrat 101 est choisi suffisamment faible pour que le champ électrique dans la zone de charge d'espace des jonctions PN formées entre les régions de type N 105_i et le substrat 101, à la périphérie des jonctions PN 109, soit suffisamment faible pour que l'avalanche ne puisse pas être déclenchée par une charge photogénérée unique, par exemple inférieur à 500 kV/cm. Ceci permet de réduire les risques de déclenchement parasite de l'avalanche liés aux effets de bord à la périphérie des jonctions PN 109.

A titre d'exemple, la tension de claquage en inverse ou tension d'avalanche de la photodiode est comprise entre 10 V et 50 V, et la tension de polarisation en inverse de la photodiode est supérieure à sa tension de claquage d'une valeur comprise entre 0,5 et 10 V. La tension d'avalanche de la photodiode dépend notamment des niveaux de dopage des régions 105_i et 107_j. A titre d'exemple, les régions de type P 107_j ont un niveau de dopage compris entre 1^{∗}10^16 et 2^{∗}10^18 atomes/cm^3, et les régions de type N 105_i ont un niveau de dopage compris entre 1^{∗}10^17 et 1^{∗}10^19 atomes/cm^3. Le niveau de dopage de chaque région de type N 105_i est par exemple de l'ordre de 1^{∗}10 ^17 atomes/cm^3 au niveau de la jonction avec la ou les régions de type P 107_j voisines. Le niveau de dopage du substrat 101 est par exemple inférieur à 5^{∗}10^16 atomes/cm^3 et de préférence inférieur à 5^{∗}10^14 atomes/cm^3.

La prévision d'une pluralité de zones d'avalanche empilées verticalement permet de collecter efficacement les charges photogénérées dans la photodiode, quelle que soit la profondeur d'absorption des photons. En particulier, dans la photodiode des figures 1 et 2, le temps moyen s'écoulant entre la photogénération d'une charge dans la photodiode et la collecte de cette charge dans une zone d'avalanche de la photodiode est sensiblement indépendant de la profondeur à laquelle la charge a été photogénérée. De plus, la sensibilité de la photodiode se trouve améliorée par rapport à une photodiode SPAD à jonction PN unique.

Pour obtenir de bonnes performances de détection, les régions 105_i et 107_j sont de préférence dimensionnées de façon que les différentes zones d'avalanche présentent sensiblement la même tension de claquage quelle que soit la profondeur de détection des photons. Autrement dit, les régions 105_i et 107_j sont de préférence telles que les différentes jonctions PN 109 de la photodiode aient sensiblement la même tension d'avalanche. Pour cela, les régions de type N 105_i ont de préférence toutes sensiblement les mêmes dimensions et le même niveau de dopage. De plus, les régions de type P 107_j ont de préférence toutes sensiblement les mêmes dimensions et le même niveau de dopage.

A titre d'exemple, les régions 105_i et 107_j ont chacune une épaisseur comprise entre 500 nm et 2 µm. Dans l'exemple des figures 1 et 2, les régions 105_i et 107_j ont sensiblement la même épaisseur. Les modes de réalisation décrits ne se limitent toutefois pas à ce cas particulier. L'épaisseur totale de l'empilement en alternance des régions 105_i et 107_j est par exemple compris entre 5 et 25 µm.

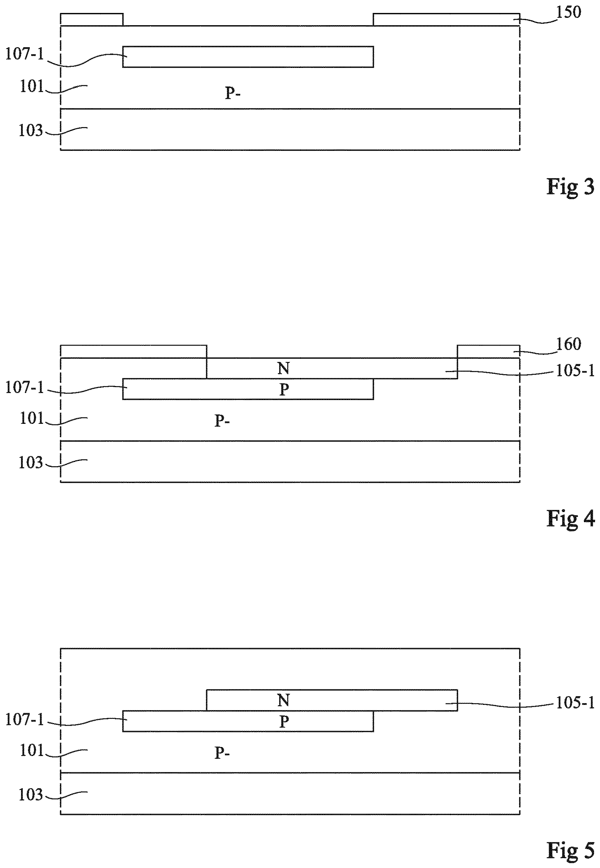

Les figures 3 à 8 sont des vues en coupe dans le même plan que la figure 1, décrivant des étapes successives d'un exemple de procédé de fabrication d'une photodiode SPAD du type décrit en relation avec les figures 1 et 2. Sur les figures 3 à 8, une unique photodiode SPAD a été représentée. Toutefois, en pratique, une pluralité de photodiodes SPAD identiques ou similaires peuvent être formées simultanément sur un même substrat de support, par exemple pour réaliser un capteur matriciel.

La figure 3 représente une étape de formation, par épitaxie, d'une première partie de l'épaisseur du substrat 101 sur la face supérieure de la couche de support 103 de la photodiode. Dans cet exemple, l'épitaxie est non localisée, c'est-à-dire que le substrat 101 s'étend sur une épaisseur sensiblement uniforme sur sensiblement toute la surface supérieure de la photodiode. L'épaisseur de substrat 101 déposée à cette étape est par exemple supérieure ou égale à la somme des épaisseurs de la région de type P 107_1 et de la région de type N 105_1 de la photodiode.

La figure 3 illustre en outre une étape ultérieure de formation de la région de type P 107_1 de la photodiode, par implantation localisée d'éléments dopants de type P dans le substrat 101 au travers d'une couche de masquage 150 préalablement formée sur la face supérieure du substrat 101 et comportant une ouverture en vis-à-vis de la région 107_1. Dans cet exemple, l'énergie d'implantation est choisie de façon à localiser la région 107_1 en profondeur dans le substrat 101, c'est-à-dire de façon que la face supérieure de la région 107_1 soit située sous la face supérieure du substrat 101. Une fois l'implantation réalisée, la couche de masquage 150 est retirée.

La figure 4 illustre une étape ultérieure de formation de la région de type N 105_1 de la photodiode, par implantation localisée d'éléments dopants de type N dans le substrat 101 au travers d'une couche de masquage 160 préalablement formée sur la face supérieure du substrat 101 et comportant une ouverture en vis-à-vis de la région 105_1. Dans cet exemple, l'énergie d'implantation est choisie de façon que la région 105_1 s'étende, en profondeur, de la face supérieure du substrat 101 à la face supérieure de la région 107_1. Une fois l'implantation réalisée, la couche de masquage 160 peut être retirée.

La figure 5 illustre une étape ultérieure de reprise de la croissance épitaxiale du substrat 101 sur la face supérieure de la structure obtenue à l'issue des étapes des figures 3 et 4. L'épaisseur additionnelle de substrat 101 déposée à cette étape est par exemple sensiblement égale à la somme des épaisseurs des régions d'anode 107_2 et de cathode 105_2 de la photodiode. Dans cet exemple, la reprise d'épitaxie est non localisée, c'est-à-dire que la portion additionnelle de substrat 101 déposée à cette étape s'étend sur une épaisseur sensiblement uniforme sur sensiblement toute la surface supérieure de la photodiode.

Les étapes d'implantation des figures 3 et 4 sont ensuite réitérées pour former les régions de type P 107_2 et de type P 105_2 de la photodiode.

L'étape de reprise d'épitaxie de la figure 5, puis les étapes d'implantation des figures 3 et 4 peuvent ensuite être réitérées autant de fois que nécessaire pour réaliser l'empilement de jonctions PN 109 de la photodiode (soit deux itérations supplémentaires pour la photodiode de la figure 1) .

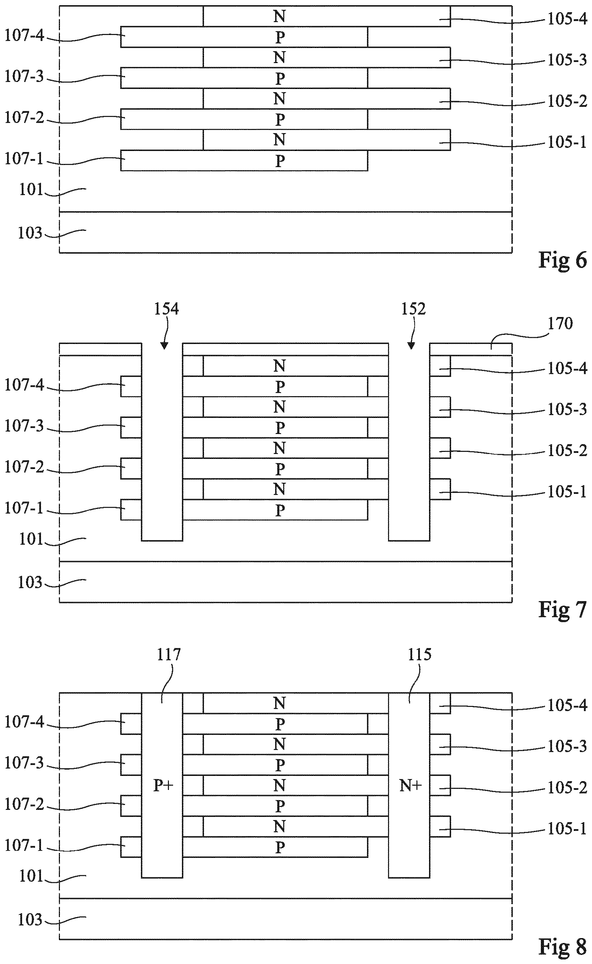

La figure 6 représente la structure obtenue à l'issue de l'ensemble des étapes successives d'épitaxie puis d'implantations localisées du procédé. On notera qu'à chaque étape d'épitaxie du procédé, le substrat 101 peut être dopé in-situ lors de la croissance épitaxiale. Le niveau de dopage du substrat 101 est de préférence sensiblement le même, par exemple de l'ordre de 1^{∗}10^16 atomes/cm^3 à chaque étape d'épitaxie. De plus, les énergies et doses d'implantation d'éléments dopants pour la formation des régions 105_i et 107_j sont de préférence sensiblement identiques à chaque itération.

A ce stade, un recuit d'activation des espèces dopantes implantées peut être réalisé, par exemple un recuit à une température comprise entre 800 et 1200°C, par exemple à une température de l'ordre de 1000°C, par exemple pendant une durée comprise entre 1 et 10 secondes. De préférence, un recuit d'activation unique commun pour toutes les régions 105_i et 107_j de la photodiode est réalisé à l'issue de l'ensemble des étapes d'épitaxie et d'implantations. Autrement dit, aucun recuit d'activation intermédiaire n'est réalisé entre deux étapes successives d'implantation des régions 105_i et 107_j de la photodiode, de façon que toutes les jonctions PN 109 de la photodiode subissent le même nombre de recuits. Ceci permet d'obtenir des tensions d'avalanche sensiblement identiques pour toutes les jonctions PN 109 de la photodiode.

La figure 7 illustre une étape ultérieure de formation d'une ouverture 152 et d'une ouverture 154, respectivement dans la partie 111 et dans la partie 113 de la photodiode, en vue de la formation des vias semiconducteurs 115 et 117 de la photodiode. Les ouvertures 152 et 154 sont formées par gravure depuis la face supérieure du substrat. Un masque de gravure 170 présentant des ouvertures traversantes délimitant, en vue de dessus, les ouvertures 152 et 154, est au préalable formé sur la face supérieure de la photodiode. L'ouverture 152 s'étend en profondeur au moins jusqu'à la face supérieure de la région de type N 105_1 de la photodiode, et l'ouverture 154 s'étend en profondeur au moins jusqu'à la face supérieure de la région de type P 107_1 de la photodiode. Dans l'exemple représenté, l'ouverture 152 traverse entièrement la région de type N 105_1 et l'ouverture 154 traverse entièrement la région de type P 107_1. Les ouvertures 152 et 154 ont par exemple sensiblement la même profondeur. La couche de masquage 170 peut ensuite être retirée.

La figure 8 illustre une étape ultérieure de remplissage de l'ouverture 152 par un matériau semiconducteur de type N pour former le via 115, et une étape de remplissage de l'ouverture 154 par un matériau semiconducteur de type P pour former le via 117. A titre d'exemple, les ouvertures 152 et 154 sont remplies respectivement de silicium polycristallin dopé de type N et de silicium polycristallin dopé de type P. A titre de variante, les ouvertures 152 et 154 peuvent être remplies par épitaxie localisée de silicium monocristallin dopé respectivement de type N pour l'ouverture 152 et de type P pour l'ouverture 154. A titre d'exemple, le niveau de dopage de type N du via 115 est compris entre 1^{∗}10^19 et 1^{∗}10^20 atomes/cm^3, par exemple de l'ordre de 5^{∗}10^19 atomes/cm^3, et le niveau de dopage de type P du via 117 est compris entre 1^{∗}10^19 et 1^{∗}10^20 atomes/cm^3, par exemple de l'ordre de 5^{∗}10^19 atomes/cm^3. Un recuit rapide d'activation des espèces dopantes des vias 115 et 117 peut être prévu à l'issue de l'étape de remplissage des ouvertures 152 et 154, par exemple un recuit à une température comprise entre 800 et 1200°C, par exemple à une température de l'ordre de 1000°C, par exemple pendant une durée comprise entre 1 et 15 secondes.

Des étapes (non détaillées) de réalisation des métallisations de contact 119 et 121 sur les faces supérieures des vias 115 et 117 et de réalisation des murs d'isolation périphériques 123 peuvent ensuite être mises en oeuvre pour obtenir la structure des figures 1 et 2.

Dans le procédé décrit en relation avec les figures 3 à 8, deux étapes d'implantation successives sont prévues après chaque étape d'épitaxie, pour former respectivement une région de type P 107_j et la région de type N 105_i immédiatement supérieure. Quatre étapes successives d'épitaxie sont donc prévues pour former la photodiode 100 de la figure 1. A titre de variante, une étape d'épitaxie spécifique peut être prévue avant chaque étape d'implantation de type P ou N, soit huit étapes d'épitaxie pour réaliser la photodiode de la figure 1.

On notera qu'avant chaque épitaxie, un nettoyage de la surface supérieure du substrat peut être prévu, par exemple au moyen d'une solution à base d'acide fluorhydrique, de façon à améliorer la qualité de l'épitaxie.

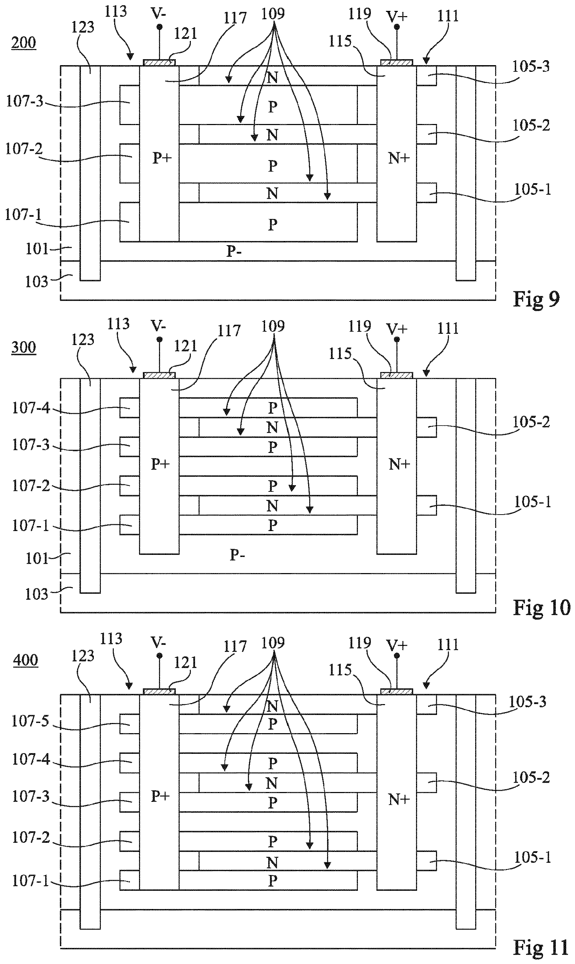

La figure 9 est une vue en coupe schématique et partielle d'un autre exemple d'une photodiode SPAD 200 selon un mode de réalisation.

La photodiode 200 de la figure 9 diffère de la photodiode 100 des figures 1 et 2 principalement en ce que, dans l'exemple de la figure 9, les régions de type P 107_j de la photodiode présentent une épaisseur supérieure à celle des régions de type N 105_i, par exemple une épaisseur comprise entre 1,5 fois et 5 fois l'épaisseur des régions de type N 105_i.

Un avantage de cette configuration est qu'elle permet d'augmenter la proportion de photons absorbés dans les régions de type P 107_j par rapport aux photons absorbés dans les régions de type N 105_i. Ceci permet d'améliorer la sensibilité de la photodiode. En effet, en cas d'absorption d'un photon dans une région de type N, l'électron de la paire électron-trou photogénérée est évacué par l'intermédiaire du via 115, et la charge photogénérée subsistante susceptible de déclencher l'avalanche est un trou, tandis qu'en cas d'absorption d'un photon dans une région de type P, le trou de la paire électron-trou photogénérée est évacué par l'intermédiaire du via 117, et la charge photogénérée subsistante susceptible de déclencher l'avalanche est un électron. La mobilité des électrons étant supérieure à celle des trous, l'avalanche est déclenchée plus aisément par un électron photogénéré que par un trou photogénéré. Autrement dit, l'avalanche est déclenchée plus aisément par un photon absorbé dans une région de type P 107_j que par un photon absorbé dans une région de type N 105_i.

Dans l'exemple de la figure 9, la photodiode 200 comprend m=3 régions de type N 105_i et n=3 régions de type P 107_j, soit 5 jonctions PN 109.

La figure 10 est une vue en coupe schématique et partielle d'un autre exemple d'une photodiode SPAD 300 selon un mode de réalisation.

La photodiode 300 de la figure 10 diffère de la photodiode 100 des figures 1 et 2 principalement en ce que, dans la photodiode 300, chaque région de type N 105_i est en contact avec deux régions de type P 107_j, chaque région de type P 107_j étant en contact avec une seule région de type N 105_i.

Plus particulièrement, dans l'exemple de la figure 10, la photodiode 300 comprend m régions 105_i dopées de type N, et n=2^{∗}m régions 107_j dopées de type P. Dans l'exemple représenté sur la figure 10, le nombre m de régions de type N 105_i est égal à 2.

Chaque région de type N 105_i est en contact, par sa face inférieure, avec la région de type P 107_j de rang j=(2^{∗}i)-1, et, par sa face supérieure, avec la région de type P de rang j=2^{∗}i. Ainsi, la photodiode 300 comprend 2^{∗}m jonctions PN 109 entre régions 105_i et 107_j voisines, soit 4 jonctions PN 109 dans l'exemple représenté.

Dans l'exemple de la figure 10, chaque région de type N 105_i, à l'exception de la région 105_m, est séparée de la région de type N 105_i+1 par une portion du substrat 101 s'étendant entre la face supérieure de la région de type P 107_j de rang j=2^{∗}i (i.e. la région 107_j en contact avec la face supérieure de la région 105_i) et la face inférieure de la région de type P 107_j de rang j=(2^{∗}i)+1 (i.e. la région 107_j en contact avec la face inférieure de la région 105_i+1).

Dans l'exemple représenté, les épaisseurs des régions 105_i et 107_j sont sensiblement identiques. A titre de variante, les régions 105_i et 107_j peuvent avoir des épaisseurs différentes.

La figure 11 est une vue en coupe schématique et partielle d'un autre exemple d'une photodiode SPAD 400 selon un mode de réalisation.

La photodiode 400 de la figure 11 diffère de la photodiode 300 de la figure 10 principalement en ce que, dans l'exemple de la figure 11, la région de type N 105_i la plus proche de la face supérieure de la photodiode, c'est-à-dire la région 105_m, est en contact avec une région de type P 107_j uniquement par sa face inférieure. Autrement dit, dans cet exemple, la photodiode comprend m régions de type N 105i et n=(2^{∗}m)-1 régions de type P 107_j, pour un total de (2^{∗}m)-1 jonctions PN 109 entre régions 105_i et 107_j voisines. Dans l'exemple représenté, la photodiode comprend m=3 régions de type N 105_i, soit un total de 5 jonctions PN 109.

Des modes de réalisation particuliers ont été décrits. Diverses variantes et modifications apparaîtront à l'homme de l'art. En particulier, les modes de réalisation décrits ne se limitent pas aux exemples numériques de dimensions et de niveaux de dopages mentionnés dans la description.

De plus, les avantages décrits ci-dessus peuvent être obtenus en inversant tous les types de conductivité par rapport aux exemples décrits en relation avec les figures 1 à 11.

Par ailleurs, les modes de réalisation décrits ne se limitent pas à l'exemple de procédé de fabrication décrit en relation avec les figures 3 à 8. A titre de variante, plutôt que de réaliser les régions 105_i et 107_j de la photodiode par des étapes successives d'implantation d'éléments dopants de type N et de type P, les régions 105_i et 107_j peuvent être réalisées par des étapes successives d'épitaxie localisée ou épitaxie sélective de type N et de type P.

## Revendications

1. Photodiode de type SPAD (100 ; 200 ; 300 ; 400) comportant, dans une partie supérieure d'un substrat semiconducteur (101) d'un premier type de conductivité, une alternance de régions (107_j) du premier type de conductivité et de régions (105_i) d'un second type de conductivité empilées verticalement, les régions (107_j) du premier type de conductivité étant en contact avec un même premier via semiconducteur (117) du premier type de conductivité et les régions (105_i) du second type de conductivité étant en contact avec un même second via semiconducteur (115) du second type de conductivité,
dans laquelle, dans une première partie (113) d'une région périphérique de la photodiode, les régions (107_j) du premier type de conductivité se prolongent latéralement au-delà des régions (105_i) du second type de conductivité, et, dans une seconde partie (111) de la région périphérique de la photodiode, les régions (105_i) du second type de conductivité se prolongent latéralement au-delà des régions (107_j) du premier type de conductivité, le premier via semiconducteur (117) étant disposé dans la première partie (113) de la région périphérique de la photodiode de façon que le premier via semiconducteur (117) ne soit pas en contact avec les régions (105_i) du second type de conductivité, et le second via semiconducteur (115) étant disposé dans la seconde partie (111) de la région périphérique de la photodiode de façon que le second via semiconducteur (115) ne soit pas en contact avec les régions (107_j) du premier type de conductivité.

2. Photodiode (100 ; 200 ; 300 ; 400) selon la revendication 1, dans laquelle ladite alternance de régions (107_j) du premier type de conductivité et de régions (105_i) du second type de conductivité forme un empilement vertical d'une pluralité de jonctions PN (109) définissant chacune une zone d'avalanche de la photodiode.

3. Photodiode (100 ; 200 ; 300 ; 400) selon la revendication 2, dans laquelle lesdites jonctions PN (109) ont toutes sensiblement la même tension d'avalanche.

4. Photodiode (100 ; 200 ; 300 ; 400) selon l'une quelconque des revendications 1 à 3, dans laquelle les régions (107_j) du premier type de conductivité ont un niveau de dopage supérieur à celui du substrat (101).

5. Photodiode (100 ; 200) selon l'une quelconque des revendications 1 à 4, dans laquelle, à l'exception des régions extrêmes de ladite alternance, chaque région (107_j) du premier type de conductivité est en contact, par sa face inférieure, avec l'une des régions (105_i) du second type de conductivité, et, par sa face supérieure, avec une autre des régions (105_i) du second type de conductivité, et chaque région (105_i) du second type de conductivité est en contact, par sa face inférieure, avec l'une des régions (107_j) du premier type de conductivité, et, par sa face supérieure, avec une autre des régions (107_j) du premier type de conductivité.

6. Photodiode (100) selon la revendication 5, dans laquelle les régions (107_j) du premier type de conductivité et les régions (105_i) du second type de conductivité ont sensiblement la même épaisseur.

7. Photodiode (200) selon la revendication 5, dans laquelle les régions (107_j) du premier type de conductivité ont une épaisseur supérieure à l'épaisseur des régions (105_i) du second type de conductivité.

8. Photodiode (300 ; 400) selon l'une quelconque des revendications 1 à 4, dans laquelle chaque région (107_j) du premier type de conductivité est en contact avec une seule région (105_i) du second type de conductivité.

9. Photodiode (300) selon la revendication 8, dans laquelle chaque région (105_i) du second type de conductivité est en contact, par sa face inférieure, avec l'une des régions (107_j) du premier type de conductivité et, par sa face supérieure, avec une autre des régions (107_j) du premier type de conductivité.

10. Photodiode (400) selon la revendication 8, dans laquelle :
- au moins l'une des régions (105_i) du second type de conductivité est en contact, par sa face inférieure, avec l'une des régions (107_j) du premier type de conductivité et, par sa face supérieure, avec une autre des régions (107_j) du premier type de conductivité ; et
- au moins une autre des régions (105_i) du second type de conductivité est en contact avec une seule des régions (107_j) du premier type de conductivité.

11. Photodiode (100 ; 200 ; 300 ; 400) selon l'une quelconque des revendications 1 à 10, dans laquelle les premier et second types de conductivité sont respectivement le type P et le type N.

12. Procédé de fabrication d'une photodiode de type SPAD (100 ; 200 ; 300 ; 400) selon l'une quelconque des revendications 1 à 11, dans lequel le substrat (101) est formé par une suite d'étapes successives d'épitaxie.

13. Procédé selon la revendication 12, dans lequel deux étapes successives quelconques de la suite d'étapes successives d'épitaxie sont séparées par au moins une étape d'implantation localisée d'éléments dopants en vue de la formation d'au moins une des régions (107_j, 105_i) du premier ou second type de conductivité.

14. Procédé selon la revendication 13, ne comprenant pas de recuit d'activation des éléments dopants entre deux étapes successives de la suite d'étapes d'épitaxie, le procédé comprenant un unique recuit d'activation des éléments dopants commun à toutes les régions (107_j, 105_i) des premier et second types de conductivité à l'issue de la suite d'étapes successives d'épitaxie.
